# EUROPÄISCHE PATENTSCHRIFT

(11) **EP 0 481 998 B1**
(45) Veröffentlichungstag und Bekanntmachung des Hinweises auf die Patenterteilung: **05.10.1994**
(21) Anmeldenummer: 90905441.3
(22) Anmeldetag: 17.04.1990
(51) Int. Cl.: H01L 21/68, H01L 21/58

(54) **UV-HÄRTBARER KLEBSTOFF FÜR EIN HALBLEITERCHIPMONTAGEVERFAHREN**
UV-CURED ADHESIVE FOR SEMICONDUCTOR-CHIP ASSEMBLY
COLLE DURCISSABLE AUX RAYONS UV POUR UN PROCEDE DE MONTAGE DE PUCES SEMI-CONDUCTRICES

(30) Priorität: 12.07.1989 DE 3923023
(43) Veröffentlichungstag der Anmeldung: 29.04.1992
(73) Patentinhaber: Siemens Nixdorf Informationssysteme Aktiengesellschaft, 33102 Paderborn (DE)
(72) Erfinder: BAYER, Heiner, Dr., D-8037 Olching (DE); LEHNER, Barbara, D-8000 München 21 (DE); WIRBSER, Oskar, D-8034 Germering (DE); UNGER, Gregor, D-8034 Germering (DE)
(74) Vertreter: Fuchs, Franz-Josef, Dr.-Ing.
(86) Internationale Anmeldenummer: DE9000290
(87) Internationale Veröffentlichungsnummer: WO9101043

(56) Entgegenhaltungen:
- EP-A- 0 110 285
- EP-A- 0 142 783
- EP-A- 0 150 882
- EP-A- 0 191 534
- EP-A- 0 253 444
- IBM Technical Disclosure Bulletin, Vol. 13, No. 12, May 1971, (New York, US), R.W. Nufer: "Chip testing and sorting", page 3652

## Beschreibung

Die Erfindung betrifft eine UV-härtbare Klebstoffzusammensetzung für ein Halbleiterchipmontageverfahren sowie dieses Montageverfahren.

Im Zuge der Entwicklung von Halbleiterbauelementen wird die Leistungsfähigkeit dieser Bauelemente durch fortschreitende Miniaturisierung der Bauelemente samt der darauf enthaltenen Strukturen gesteigert. Erfordern technische Gründe für ein Bauelement eine bestimmte räumliche Größe, die über die eines einzelnen Bauelements hinausgeht, so wird ein großes Bauelement oft in Modulbauweise aus kleineren Einheiten zusammengesetzt. In Abhängigkeit von der Komplexität der Schaltungen bzw. der Größe der darauf enthaltenen Strukturen kann beim Zusammenbau der Einzelmodule, welche gleichartig oder auch verschieden sein können, eine räumlich exakte Relativanordnung der Einzelmodule zueinander bzw. zum Substrat oder Träger erforderlich sein. Die maximal erlaubten Fehlertoleranzen können dabei im Bereich weniger µm und oft auch darunter liegen.

In der WO 89/08896 ist zum Beispiel ein auf dem elektrophotographischen Prinzip funktionierender nichtmechanischer Drucker beschrieben. Dessen Zeichengenerator enthält eine Vielzahl von Lichtquellen, die in einer Belichtungszeile angeordnet sind. Dabei handelt es sich üblicherweise um Leuchtdioden (LEDs), die zum Beispiel in zwei Reihen zu je 64 LEDs auf einem monolithischen Chip integriert sind. Die Chips wiederum werden auf einzelnen Modulen zusammengefaßt, aus denen wiederum sich je nach zu bedruckendem Papierformat die Belichtungszeile zusammensetzen läßt. Die erreichbare Druckqualität ist von der Feinheit des Rasters, also vom Abstand der Einzel-LEDs auf dem Chip abhängig. Höchstauflösende Zeichengeneratoren erreichen heute ein Druckraster von 600 Dots per Inch (DpI). Bei einer Belichtungszeile von 450 mm Breite entspricht dies zum Beispiel einer Menge von über 10.000 Einzel-LEDs, die in zwei auf Lücke versetzten Reihen nebeneinander angeordnet sind. Um die Druckqualität bei dieser Zeichendichte nicht zu verschlechtern ist es nötig, bei der Montage der Einzelchips auf einem Modul eine Fehlertoleranz von ± 2 µm einzuhalten. Dazu müssen die Einzelchips bei der Montage auf dem Modul vor der endgültigen Befestigung exakt ausgerichtet werden. Nach dem Ausrichten darf sich während des Befestigens die Lage der Chips nicht mehr verändern. Für den üblicherweise dazu verwendeten Lötprozeß erfordert dies allerdings umfangreiche Vorkehrungen, da das Lot beim Löten bekanntlich erweicht, ein Verrutschen der Chips aber gerade vermieden werden soll.

Durch Kleben können Chips zwar positionsgenau fixiert werden, doch ist aufgrund der hohen Leistungsdichte der integrierten Chips während des Betriebs eine hohe Verlustwärme abzuführen, was nur über eine Lötverbindung möglich ist.

In der DE-A- 38 08 667 wird vorgeschlagen, die Chips in einer zum fertigen Modul spiegelverkehrten Anordnung auf einem Hilfsträger aufzukleben, wobei bereits die exakte Ausrichtung erfolgt. In dieser fixierten Form werden die Chips dann auf das eigentliche Modul aufgelötet. Nach Beendigung des Lötprozesses wird die Klebeverbindung gelöst und somit der Hilfsträger entfernt. Allerdings konnte für diesen Prozeß bisher kein geeigneter Klebstoff gefunden werden, der sowohl eine rasche im Lötprozeß beständige Fixierung der Chips auf dem Hilfsträger erlaubt, als auch nach dem Lötprozeß vollständig wieder entfernbar ist.

Aus IBM Technical Disclosure Bulletin 13, (1971) Seite 3652 ist es bekannt, einen Halbleiterwafer mit Hilfe eines Photoresists auf einem Hilfsträger zu verkleben, den Wafer in einzelne Chips zu zerteilen, die Verklebung funktionsfähiger Chips mittels UV-Licht zu fixieren und schließlich die fixierten Verklebungen mit Hilfe eines Lösungsmittels wieder zu lösen.

Aus der EP-0 142 783 ist ein Verfahren zur Montage von Halbleiterbauelementen auf einem Substrat bekannt, bei dem die Bauelemente zunächst mit Hilfe eines Styrol-Polymere enthaltenden thermisch härtbarten Klebers auf das Substrat aufgeklebt werden. Nach thermischer Härtung werden die Bauelemente aufgelötet und schließlich der Klebstoff mit Hilfe eines Lösungsmittels wieder entfernt.

Aufgabe der vorliegenden Erfindung ist es daher, einen mit UV-Licht härtbaren Klebstoff anzugeben, welcher eine schnelle und sichere Fixierung der Chips zum Beispiel auf dem Hilfsträger erlaubt, gegenüber dem Lötprozeß beständig ist und danach rückstandsfrei zu entfernen ist.

Diese Aufgabe wird durch eine UV-härtbare Klebstoffzusammensetzung gelöst, welche erfindungsgemäß aufweist
A) mindestens ein monofunktionelles (Meth-) Acrylat eines aliphatischen oder cycloaliphatischen Alkohols mit 6 - 20 C-Atomen,
B) einen mehrfunktionellen reaktiven Vernetzer auf der Basis eines niedermolekularen aliphatischen, mit (Meth-) Acrylsäure veresterten Mehrfachalkohols,
C) mit Acrylaten copolymerisierbare, leicht vernetzend wirkende Oligo- oder Polymere mit olefinisch ungesättigten Gruppen zur Flexibilisierung,
D) ein Photoinitiatorsystem für UV-Licht, sowie
E) einen thermisch aktivierbaren Radikalstarter,

aus welcher sich eine gegenüber einem Lötprozeß beständige Klebeverbindung darstellen läßt, die auch nach dem Lötprozeß mit einem Lösungsmittel rückstandsfrei auflösbar ist.

Weitere Ausgestaltungen der Erfindung sowie ein Verfahren zur Montage von Halbleiterchips auf einem Bauelement sind den Unteransprüchen zu entnehmen.

Bei der erfindungsgemäßen Klebstoffzusammensetzung handelt es sich um eine unter UV-Bestrahlung schnell härtende Masse. Dies ist insbesondere dann von Vorteil, wenn eine Vielzahl von Halbleiterbauelementen auf einem Träger oder Modul montiert werden sollen, wobei die Bauelemente vorteilhafterweise einzeln ausgerichtet und sofort fixiert werden. Die für die Fixierung sämtlicher Halbleiterbauelemente auf dem Träger oder Modul erforderliche Zeit stellt dann das Produkt der Aushärtungsdauer für eine Klebeverbindung mit der Anzahl der auf dem Modul zu montierenden Bauelemente dar. Die im Sekundenbereich liegende Aushärtedauer der erfindungsgemäßen Klebstoffzusammensetzungen ist daher besonders vorteilhaft, da sie nur kurze Maschinenbelegungszeiten erfordert und eine wirtschaftliche Montage ermöglicht.

Die durch die UV-Härtung bereits unverrückbar fixierten Klebeverbindungen werden in einem thermischen Prozeß vollständig durchgehärtet. Dies wird durch die thermisch aktivierbaren, in der Klebstoffzusammensetzung enthaltenen Radikalstarter bewirkt. Eine Vielzahl von dafür geeigneten Verbindungen ermöglicht über eine zum Beispiel von der Zerfallstemperatur der Radikalstarter abhängigen Auswahl eine Anpassung der Aushärtung an eine gewünschte Temperatur.

Bei der erfindungsgemäßen Zusammensetzung handelt es sich um eine ausgewogene Mischung mono- und mehrfunktioneller Bestandteile, die eine auch thermisch ausreichend strukturstabile Harzmatrix ergeben, gleichzeitig aber ausreichend wenig vernetzte Polymere enthält, um ein problemloses Auflösen der gehärteten Klebstoffzusammensetzungen in organischen Lösungsmitteln zu gewährleisten. Damit wird ein völlig neues Eigenschaftsprofil der Klebstoffzusammensetzung erzielt, das an sich sich widersprechende Zielsetzungen in unerwarteter und gleichwohl vorteilhafter Weise vereint.

Für die UV-Empfindlichkeit ist ein Photoinitiatorsystem vorgesehen, welches gegenüber einem grundsätzlich ebenfalls möglichen einzelnen Photoinitiator weitere Vorteile erbringt. Dies ist insbesondere eine höhere Empfindlichkeit bezüglich der Intensität und dem abgedeckten Wellenlängenbereich des zur Härtung verwendeten Lichts. Die Empfindlichkeit des Photoinitiatorsystems und damit der gesamten Klebstoffzusammensetzung ist dabei so bemessen, daß deren Verarbeitung bei künstlicher Beleuchtung möglich ist, ohne daß es dabei zu einem unerwünschten vorzeitigen Härten und dem damit verbundenen Viskositätsanstieg der Klebstoffzusammensetzung kommt. Außerdem wird die genaue Position der Halbleiterbauelemente auf dem Modul vor dem Fixieren üblicherweise mit optischen Methoden bestimmt, die bei entsprechender Langwelligkeit der zur Messung verwendeten Strahlung ebenfalls keine vorzeitige Härtung der Klebstoffzusammensetzung bewirkt. Diese ist im übrigen in Schichtdicken von zum Beispiel 5 µm stempelbar und zeigt eine gute Haftung auf Glas, Metall und Chipoberflächen, welche die im angegebenen Montageprozeß für eine LED-Zeile vorzugsweise verwendeten Trägermaterialien bzw. Oberflächen darstellen.

Der wahlweise Zusatz eines Pigmentfarbstoffes zu der üblicherweise farblosen Klebstoffzusammensetzung ermöglicht eine optische Kontrolle des Klebstoffauftrags bzw. dessen Entfernung durch Lösungsmittel.

Coinitiatoren können die Härtung beschleunigen, zum Beispiel durch Ausschluß der Sauerstoffinhibierung beim Härtungsprozeß. Allgemein bewirkt die Anwesenheit von Sauerstoff bei einem durch Licht härtenden Gemisch eine Abnahme der Reaktionsgeschwindigkeit, die besonders in oberflächennahen Bereichen bis zur Inhibierung führen kann. Durch geeignete Zusätze, wie sie auch in der erfindungsgemäßen Klebstoffzusammensetzung enthalten sind, läßt sich die Sauerstoffinhibierung reduzieren, so daß ein Verarbeiten der Klebstoffzusammensetzung auch in einer Normalatmosphäre möglich ist. Diese kann daher maschinell oder per Hand erfolgen.

Als niedermolekulare und monofunktionelle Acrylate oder Methacrylate werden diejenigen von aliphatischen oder cycloaliphatischen Alkoholen mit 6 bis 20 C-Atomen ausgewählt. In der Zusammensetzung sind sie bevorzugt in einem Anteil von 30 bis 70 Gewichtsprozent enthalten. Die monofunktionellen Verbindungen stellen die besser löslichen Komponenten einer Klebeverbindung aus der gehärteten Klebstoffzusammensetzung dar. Als Homopolymere bilden sie lineare und unvernetzte Polymere aus und sind daher gut löslich. In der Klebstoffzusammensetzung machen sie den Hauptbestandteil aus und bestimmen daher mit ihren Eigenschaften auch überwiegend die Eigenschaften der Klebstoffzusammensetzung bzw. einer gehärteten Klebeverbindung. Acrylate von aliphatischen bicyclischen Alkoholen besitzen starre Molekülgerüste, härten schwundarm und weisen als Homopolymer eine hohe Glasübergangstemperatur auf, die sich auch mit zunehmendem Anteil an der Klebstoffzusammensetzung auf diese übertragen läßt. Weitere monofunktionelle Acrylate können von linearen aliphatischen Alkoholen abgeleitet sein. Deren relativ langer und gut beweglicher aliphatischer Rest macht diese zu einem die Viskosität einer Klebeverbindung herabsetzenden Komponente. Als Homopolymere ergeben sie gel-bis gummiartige Polymere mit guter Löslichkeit und niedriger Glasübergangstemperatur. Als Monomere sind sie niederviskos und verdünnen die Klebstoffzusammensetzung, so daß sich über deren Anteil eine für die Verarbeitung geeignete Viskosität der Klebstoffzusammensetzung einstellen läßt. Zur Anwendung der Klebstoffzusammensetzung im Stempelauftrag ist zum Beispiel eine Viskosität von ca. 600 mPas oder weniger geeignet.

Als sogenannter Vernetzungsverstärker ist in der Klebstoffzusammensetzung ein mehrfunktionelles Acrylat enthalten, vorzugsweise ein mit Acrylsäure bzw. Methacrylsäure veresterter niedermolekularer aliphatischer Mehrfachalkohol. Beim Härtungsprozeß sorgt er für eine Vernetzung der Klebstoffzusammensetzung und erhöht dabei die mechanische Härte und Festigkeit, wobei gleichzeitig die Löslichkeit der gehärteten Klebstoffzusammensetzung herabgesetzt wird. Er weist vorteilhafterweise drei und mehr funktionelle Gruppen auf und kann daher zum Beispiel von Pentaerythrithol, Trimethylolpropan oder ähnlichen Verbindungen abgeleitet sein. Der Anteil des Vernetzungsverstärkers an der Klebstoffzusammensetzung ist kritisch bezüglich der Eigenschaften der gehärteten Klebeverbindung und liegt je nach verwendetem Polymersystem zwischen 3 und 15 Gewichtsprozent.

Als Komponente C) enthält die erfindungsgemäße Klebstoffzusammensetzung ein Oligo- oder Polymer, welches im wesentlichen linear ist und mehrere funktionelle Gruppen aufweist. Es dient zur Elastifizierung der gehärteten Klebeverbindung und enthält mehrere polymerisierbare olefinisch ungesättigte Gruppen, beispielsweise Vinyl- oder Acrylgruppen. Es wirkt leicht vernetzend, wobei auf ca. 1000 Mol-Gewichtseinheiten eine vernetzbare Gruppe im Polymer (Komponente C) enthalten ist. Gut verträglich mit den angegebenen übrigen Komponenten ist beispielsweise ein Copolymer aus Butadien/Acrylnitril mit Vinylendgruppen, das in einem Anteil von 10 bis 50 Gewichtsprozent in der Klebstoffzusammensetzung enthalten sein kann. Über diese Komponente werden weitere mechanische Eigenschaften wie beispielsweise Zugfestigkeit und Elastizität eingestellt. Auch die Lösbarkeit der gehärteten Klebeverbindung wird von der Komponente C positiv beeinflußt.

Das Photoinitiatorsystem (Komponente D) ist so ausgewählt, daß das Empfindlichkeitsmaximum zwischen 300 und 400 nm liegt, wobei gegenüber längerwelligem Licht eine ausreichend lange Beständigkeit gegeben ist. Das heißt, daß bei Tageslicht bzw. Raumbeleuchtung eine ausreichend lange Verarbeitungszeit möglich ist, in der die Viskosität nicht zu stark ansteigt, so daß Klebstoffauftrag, Ausrichten und Fixieren der Halbleiterchips problemlos erfolgen kann. Ansonsten erfolgt die Auswahl des Photoinitiatorsystems ohne weitere Einschränkungen, wobei geeignete Systeme in ausreichender Zahl bekannt sind. Die zuzugebene Menge richtet sich nach der gewünschten Aushärtgeschwindigkeit, bzw. nach der erforderlichen Handhabungsdauer bis zur Aushärtung.

Zur Ausschaltung der Sauerstoffinhibierung sind geeignete tertiäre Amine enthalten.

Auch die Auswahl des Radikalstarters ist problemlos, da er aufgrund seines geringen Anteils in der Klebstoffzusammensetzung deren übrige Eigenschaften kaum oder gar nicht beeinflußt. Gut geeignet sind beispielsweise eine Reihe von Peroxiden, wobei als Auswahlkriterium zum Beispiel die gewünschte Zerfallstemperatur bzw. eine ausreichende Lagerstabilität bei Raumtemperatur und eine möglichst niedrige Härtungstemperatur dienen kann.

Der erfindungsgemäße Kleber kann insbesondere zu einem Verfahren zur Montage von Halbleiterchips auf einem Bauelement verwendet werden, welches erfindungsgemäß durch folgende Verfahrensschritte gekennzeichnet ist:
- Aufbringen einer UV-härtbaren Klebstoffschicht auf den als Klebestellen vorgesehenen Bereichen eines Hilfsträgers,
- Aufsetzen der zu montierenden Halbleiterchips über den Klebestellen auf dem Hilfsträger mit der aktiven der späteren Lötstellegegenüberliegenden Seite in spiegelverkehrter Anordnung (gegenüber der späteren Montage auf dem Bauelement),
- Bestimmen der genauen Positionen der Halbleiterchips auf dem Hilfsträger relativ zu einer vorgegebenen Position und gegebenenfalls Ausrichten der Halbleiterchips entsprechend diesen vorgegebenen Positionen,
- Fixieren der Positionen der Halbleiterchips durch Bestrahlung der Klebstoffschicht mit UV-Licht,
- Aushärten der Klebstoffschicht bei erhöhter Temperatur,
- Auflöten der auf dem Hilfsträger aufgeklebten Halbleiterchips mit der Rückseite auf dem Bauelement in einem Lötverfahren sowie
- Lösen der Klebeverbindung zwischen den Halbleiterchips und dem Hilfsträger und Auflösen sämtlicher Klebstoffreste auf den Halbleiterchips mittels eines Lösungsmittels.

In dem ebenfalls erfindungsgemäßen Verfahren werden die bisher nicht bekannten Eigenschaften der erfindungsgemäßen Klebstoffzusammensetzung in vorteilhafter Weise ausgenützt. Es handelt sich dabei um ein sogenanntes Umlötverfahren, bei dem mehrere Halbleiterchips in der gewünschten allerdings spiegelverkehrten Anordnung zunächst auf einem Hilfsträger aufklebt werden. Da der Kleber UV-härtend ist, können die Klebeverbindungen der Chips auf dem Hilfsträger überprüft und gegenüber einem vorgegebenen Wert nachreguliert werden, bevor diese Position mittels Bestrahlung fixiert wird. Der Klebstoff härtet im UV-Licht innerhalb weniger Sekunden, so daß es möglich ist, jeden Chip einzeln aufzusetzen, auszurichten und zu fixieren. Die bereits mechanisch fixierte Klebeverbindung wird für kurze Zeit einer erhöhten Temperatur ausgesetzt, wobei ein vollständiges Aushärten der Klebstoffschicht erfolgt. Die exakte Ausrichtung bzw. Position der Halbleiterchips auf dem Hilfsträger bleibt dabei erhalten.

In einem Lötprozeß werden nun die auf dem Hilfsträger fixierten Halbleiterchips auf den endgültigen Träger, zum Beispiel ein Bauelement, gelötet. Je nach angewendetem Lötverfahren wird dabei die gehärtete Klebstoffschicht einer Temperatur bis ca. 215°C ausgesetzt. Auch hierbei bleibt die exakte Ausrichtung der Chips auf dem Hilfsträger erhalten, so daß sie beim Härten des Lots auch auf den Bauelement erzielt wird.

Nach dem Erkalten des Lotes sind die Chips auf dem Bauelement fixiert, so daß nun der Hilfsträger abgelöst werden kann. Das Auflösen der Klebstoffschicht geschieht mit insbesondere organischen Lösungsmitteln, wobei sich die Ablösung vollständig und rückstandsfrei durchführen läßt.

Das Bestimmen der genauen Position des Halbleiterchips auf dem Hilfsträger kann mittels optischer Methoden vorgenommen werden, insbesondere über ein Mikroskop. Die Position der Halbleiterchips kann dabei relativ zueinander oder absolut zu dem Träger bestimmt werden, wobei im letzteren Fall Meßmarken auf dem Träger vorgesehen sein können. Vorteilhafterweise wird die optische Messung bei einer Wellenlänge vorgenommen, die außerhalb des Empfindlichkeitsbereichs der Klebstoffzusammensetzung bzw. dessen Photoinitiator liegt. Liegt der Empfindlichkeitsbereich wie angegeben zwischen 300 und 400 nm, so kann für das Mikroskoplicht ein Farbfilter, zum Beispiel ein Gelbfilter, vorgesehen sein, um kürzerwellige Bestandteile des Mikroskoplichts auszufiltern.

Zum Fixieren der Klebeverbindung ist eine beliebige UV-Lichtquelle ausreichend, deren Licht beispielsweise über einen Lichtleiter an die Klebeverbindung herangeführt werden kann. So ist es möglich, einzelne Klebestellen zu fixieren, ohne dabei gleichzeitig den bereits aufgetragenen Klebstoff für die später zu fixierenden Halbleiterchips zu härten.

Zur endgültigen Montage der auf dem Hilfsträger fixierten Halbleiterchips auf dem Bauelement kann zum Beispiel ein Dampfphasenlöten (vapour-phase-Prozeß) durchgeführt werden. Dazu wird an der vorgesehenen Lötstelle auf dem Bauelement eine Lotpaste aufgetragen, beispielsweise durch Stempeln oder Siebdruck. Nun werden die Halbleiterchips mit dem Hilfsträger über der Lötstelle fixiert. Die für den Lötprozeß nötige Wärme wird über inerte organische Dämpfe zugeführt. Dabei wird die gesamte Anordnung für mehrere Minuten Temperaturen von bis zu ca. 215°C ausgesetzt. Die Klebeverbindung der Halbleiterchips zu dem Hilfsträger übersteht sowohl die organischen Dämpfe als auch die erhöhte Temperatur unversehrt.

Nach dem Erkalten des Lots wird die Klebeverbindung mit einem organischen Lösungsmittel behandelt und dadurch vollständig aufgelöst. Die Behandlung kann durch Besprühen, Spülen oder Tauchen mit dem Lösungsmittel erfolgen. Dazu sind insbesondere stark polare Lösungsmittel oder Mischungen mehrerer Lösungsmittel geeignet. Vorteilhaft kann auch ein basischer Photolackstripper eingesetzt werden. Dabei und auch während des gesamten übrigen Verfahrens wird keinerlei Korrosion der Halbleiterbauelemente bzw. der metallenen Anschlußstellen (bond-pads), welche zum Beispiel aus Aluminium bestehen, beobachtet.

Bei weniger wirksamen Lösungsmitteln kann das Ablösen der Klebstoffschicht in einem Bad erfolgen und durch Temperaturerhöhung, mechanisch oder mit Ultraschall unterstützt werden.

Im folgenden wird die Erfindung durch ein Ausführungsbeispiel und die dazugehörigen vier Figuren näher erläutert. Dabei zeigen die Figuren verschiedene Verfahrensstadien bei der Montage von Halbleiterchips auf einem Bauelement unter Verwendung eines Hilfsträgers.

### Ausführungsbeispiel:

Eine ausgewählte Klebstoffzusammensetzung enthält zum Beispiel die folgenden Komponenten, wobei die Mengen in Masseteilen (MT), und in Klammern Handelsname und Hersteller angegeben sind.
- 10,0 MT: Octyldecylacrylat (ODA, Interez)
- 60,0 MT: Isobornylacrylat (IBA, Alcolac)
- 10,0 MT: ethoxyliertes Trimethylolpropantriacrylat (TMPEOTA, Interez)
- 40,0 MT: vinylterminiertes Butadien-Acrylnitril-Butadien-Copolymer (Hycar 1300 X23, Hycar)
- 6,0 MT: 2-(Dimethylamino)ethylbenzoat (DMB, Shell)
- 2,0 MT: 2-Methyl-1-(4-(methylthio)phenyl)-2-morpholino-propanon-1 (Irgacure 907, Ciba Geigy)
- 2,0 MT: Isopropylthioxanthon (ITX, Shell)
- 2,0 MT: 1,1-Bis (t-butylperoxy)-3,3,5-trimethylcyclohexan (Luperox 231-50, Fa. Luperox)
- 0,5 MT: Rote Pigmentdispersion (LI-777, Loctite)

Bei der angegebenen Klebstoffzusammensetzung handelt es sich um eine gut stempelbare Masse mit einer Viskosität von unter 600 mPas, welche zum Beispiel aus Glas oder Metall bestehende Oberflächen gut benetzt und darauf auch nach Härtung gut haftet.

Es sollen nun mehrere Halbleiterchips in einer vorgegebenen Anordnung und mit hoher Genauigkeit (Fehlertoleranz zum Beispiel ± 2 µm) auf einem Bauelement montiert werden. Dazu wird wie folgt verfahren:

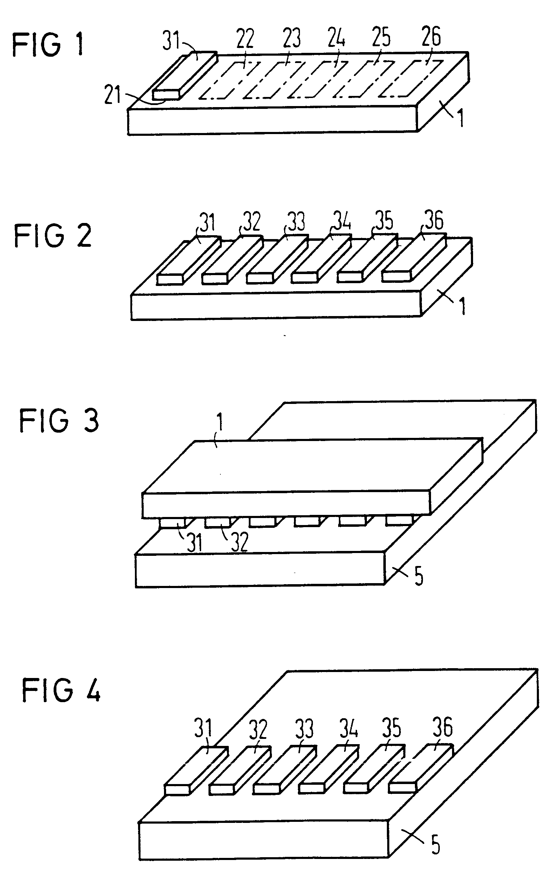

Figur 1: Auf einem Hilfsträger 1, welcher zum Beispiel aus Glas oder Metall besteht, wird an vorgegebenen Klebestellen jeweils eine Klebstoffschicht (21 bis 26) aus der oben angegebenen Masse aufgetragen. Dazu eignet sich beispielsweise ein Stempelverfahren, mit dem 5 µm dicke Schichten 21 bis 26 erzeugt werden. Die rot eingefärbte aber transparente Masse ist an Luft gut verarbeitbar und zeigt dabei keinen merklichen Viskositätsanstieg. Ein erster Halbleiterchip 31 wird nun auf der Klebstoffschicht 21 aufgesetzt. Über ein Mikroskop (in der Figur nicht dargestellt) wird die genaue Position des Halbleiterchips 31 auf den Hilfsträger 1 überprüft und gegebenenfalls nachreguliert. Als Hilfsmittel können dazu auf dem Träger 1 Markierungen angebracht sein, die bei einem aus Glas bestehenden Hilfsträger in durchscheinender Beleuchtung erkannt werden, bei einem aus Stahl bestehenden Hilfsträger durch geeignete andere Methoden. Das Aufsetzen und Ausrichten der Halbleiterchips erfolgt üblicherweise vollautomatisiert. Nach dem Ausrichten des ersten Halbleiterchips 31 auf dem Hilfsträger 1 wird die Klebstoffschicht 21 durch Bestrahlung mit UV-Licht leicht angehärtet und die Klebeverbindung so fixiert. Dazu können mit Hilfe eines Lichtleiters die in der Anordnung (1, 21, 31) noch zugänglichen Bereiche der Klebstoffschicht 21 belichtet werden, wobei die übrigen auf dem Hilfsträger 1 vorhandenen Klebstoffschichten 22 bis 26 nicht von der Belichtung erfaßt und somit auch nicht gehärtet werden.

Figur 2 zeigt den Hilfsträger 1, bei dem in entsprechender Weise weitere Halbleiterchips 32 bis 36 auf dem entsprechenden Klebstoffschichten 22 bis 26 nacheinander aufgebracht, ausgerichtet und fixiert wurden. Die relative Position der Halbleiterchips 31 bis 36 entspricht der spiegelverkehrten für die Montage auf dem Bauelement vorgesehenen Anordnung, da die Halbleiterchips 31 bis 36 mit der späteren Oberseite auf dem Hilfsträger aufgeklebt sind. Die die Klebeverbindungen darstellenden Klebstoffschichten sind soweit gehärtet, daß die Halbleiterchips unverrückbar fixiert sind. Zur vollständigen Durchhärtung der Klebstoffschichten bzw. der Klebeverbindungen wird die in der Figur 2 dargestellte Anordnung für kurze Zeit auf eine erhöhte Temperatur von ca. 120°C gebracht. Die in der Klebstoffzusammensetzung enthaltenen Peroxide zerfallen dabei unter Radikalbildung und initiieren die vollständige Vernetzung und Härtung der Klebstoffschicht.

Auf dem Bauelement wird nun in den zur Montage vorgesehenen Bereichen eine Lotpaste aufgebracht, beispielsweise durch Siebdruck. Mit der noch freien Oberfläche nach unten werden die auf dem Hilfsträger 1 montierten Halbleiterchips 31 bis 36 an der vorgesehenen Position über der Lotpaste aufgesetzt und in geeigneter Weise mechanisch fixiert. In einer Dampfphasenlötanlage wird nun die aus Hilfsträger und Bauelement samt dazwischenliegenden Halbleiterchips bestehende Anordnung für kurze Zeit auf bis zu 215°C erhitzt, wobei das in der Lotpaste enthaltene Lot aufschmilzt. Die Klebeverbindung der Halbleiterchips 31 bis 36 zum Hilfsträger 1 widersteht sowohl den hohen Temperaturen, als auch den Dämpfen des zur Wärmeübertragung eingesetzten organischen Lösungsmittels (zum Beispiel Freon), ohne daß dabei die Halbleiterchips ihre Position ändern.

Figur 3 zeigt die Anordnung, bei der nach dem Erkalten des Lotes die auf dem Hilfsträger 1 fixierten bzw. geklebten Halbleiterchips 31 bis 36 nun durch eine Lötverbindung fest auf dem Bauelement 5 montiert sind. Mit einem geeigneten Lösungsmittel bzw. einem Lösungsmittelgemisch werden nun die Klebeverbindungen der Halbleiterchips 31 bis 36 zu dem Hilfsträger 1 gelöst. Beispielsweise kann die Klebeverbindung dazu mit einem Stripper für Photolacke besprüht werden. Durch Aufquellen der Klebstoffschicht wird zunächst die Klebeverbindung zum Hilfsträger gelöst und schließlich infolge weiterer Behandlung sämtliche Klebstoffreste auf den Halbeiterchips 31 bis 36 entfernt.

Figur 4 zeigt die Anordnung nach dem Entfernen des Hilfsträgers und der Klebstoffreste. Das Verfahren ist dabei nicht auf eine wie in den Figuren dargestellte einfache Anordnung der Halbleiterchips beschränkt, vielmehr können auch komplexe Anordnungen auch verschiedener Halbleiterchips auf einem Bauelement montiert werden. Die dabei erzielte Genauigkeit in der Anordnung ist durch direktes Löten nicht oder nur mit großem Aufwand möglich. Trotz des Umwegs über die hilfsweise Fixierung der Halbleiterchips auf dem Hilfsträger handelt es sich dennoch um ein schnelles Verfahren, da die Fixierung der Klebeverbindung nur wenige Sekunden erfordert. Aufsetzen und Ausrichten der Halbleiterchips auf dem Hilfsträger erfolgen in für hochautomatisierte Prozesse gewohnter Schnelligkeit.

## Patentansprüche

1. UV-härtbare Klebstoffzusammensetzung, insbesondere für die Montage von Halbleiterchips, aufweisend
A) mindestens ein monofunktionelles (Meth-) Acrylat eines aliphatischen oder cycloaliphatischen Alkohols mit 6 - 20 C-Atomen,
B) einen mehrfunktionellen reaktiven Vernetzer auf der Basis eines niedermolekularen aliphatischen, mit (Meth-) Acrylsäure veresterten Mehrfachalkohols,
C) mit Acrylaten copolymerisierbare, leicht vernetzend wirkende Oligo- oder Polymere mit olefinisch ungesättigten Gruppen zur Flexibilisierung,
D) ein Photoinitiatorsystem für UV-Licht, sowie
E) einen thermisch aktivierbaren Radikalstarter,
aus welcher sich eine gegenüber einem Lötprozeß beständige Klebeverbindung darstellen läßt, die auch nach dem Lötprozeß mit einem Lösungsmittel rückstandsfrei auflösbar ist.

2. Klebstoffzusammensetzung nach Anspruch 1, **dadurch gekennzeichnet**, daß weitere übliche Zusätze enthalten sind wie Coinitiatoren, Stabilisatoren oder Pigmente.

3. Klebstoffzusammensetzung nach Anspruch 1 oder 2, **da****durch gekennzeichnet**, daß die Komponente A in einem Anteil von 30 bis 70 Gewichtsprozent enthalten ist.

4. Klebstoffzusammensetzung nach einem der Ansprüche 1 bis 3, **dadurch gekennzeichnet**, daß als Komponente C ein Butadien/Acrylnitril-Copolymer mit Vinyl-Endgruppen in einem Anteil von 10 bis 50 Gewichtsprozent enthalten ist.

5. Klebstoffzusammensetzung nach mindestens einem der Ansprüche 1 bis 4, **dadurch gekennzeichnet,** daß als Radikalstarter ein Peroxid enthalten ist.

6. Klebstoffzusammensetzung nach mindestens einem der Ansprüche 1 bis 5, **dadurch gekennzeichnet**, daß ein geeignetes Amin enthalten ist, welches die Sauerstoff-Inhibierung bei der UV-Härtung der Klebstoffzusammensetzung ausschaltet.

7. Klebstoffzusammensetzung nach mindestens einem der Ansprüche 1 bis 6, **dadurch gekennzeichnet**, daß ein Photoinitiatorsystem enthalten ist, welches überwiegend für Licht unterhalb von 400 nm empfindlich ist.

8. Verfahren zur Montage von Halbleiterchips (31, 32...36) auf einem Bauelement (5) mit Hilfe einer Klebstoffzusammensetzung nach Anspruch 1, **gekennzeichnet durch** folgende Verfahrensschritte:
- Aufbringen einer UV-härtbaren Klebstoffschicht nach Anspruch 1 auf den als Klebestellen (21, 22...26) vorgesehenen Bereichen eines Hilfsträgers,
- Aufsetzen der zu montierenden Halbleiterchips (31..) über den Klebestellen (21..) auf den Hilfsträger (1) mit der aktiven, der späteren Lötstelle gegenüberliegenden Seite in spiegelverkehrter Anordnung (gegenüber der späteren Montage auf dem Bauelement 5),
- Bestimmen der genauen Positionen der Halbleiterchips auf dem Hilfsträger (1) relativ zu einer vorgegebenen Position und gegebenenfalls Ausrichten der Halbleiterchips entsprechend dieser vorgegebenen Positionen,
- Fixieren der Positionen der Halbleiterchips durch Bestrahlung der Klebstoffschicht mit UV-Licht,
- Aushärten der Klebstoffschicht bei erhöhter Temperatur,
- Auflöten der auf dem Hilfsträger (1) aufgeklebten Halbleiterchips mit der Rückseite auf dem Bauelement (5) in einem Lötverfahren sowie
- Lösen der Klebeverbindung zwischen den Halbleiterchips und dem Hilfsträger und Auflösen sämtlicher Klebstoffreste auf den Halbleiterchips mittels Lösungsmittel.

9. Verfahren nach Anspruch 8, **dadurch gekennzeichnet**, daß das Bestimmen der relativen Positionen der Halbleiterchips (31) auf dem Träger mittels optischer Meßmethoden, insbesondere über ein Mikroskop vorgenommen wird und daß aus dem dafür verwendeten Licht mittels eines Farbfilters die kürzerwelligen Bestandteile herausgefiltert werden.

10. Verfahren nach einem der Ansprüche 8 oder 9, **dadurch gekennzeichnet**, daß das zum Fixieren der Klebeverbindung verwendete Licht über einen Lichtleiter herangeführt wird.

11. Verfahren nach einem der Ansprüche 8 bis 10, **dadurch gekennzeichnet**, daß als Lötverfahren ein Dampfphasenlöten (= vapour phase Prozeß) durchgeführt wird.

12. Verfahren nach mindestens einem der Ansprüche 8 bis 11, **dadurch** **gekennzeichnet**, daß als Lösungsmittel ein Photolackstripper verwendet wird.

13. Verfahren nach mindestens einem der Ansprüche 8 bis 12, **dadurch gekennzeichnet**, daß eine durch einen der Ansprüche 1 bis 7 beschriebene Klebstoffzusammensetzung verwendet wird.

## Claims

1. UV-curable adhesive composition, in particular for mounting semiconductor chips, containing
A) at least one monofunctional (meth)acrylate of an aliphatic or cycloaliphatic alcohol containing 6 - 20 carbon atoms,
B) a polyfunctional reactive crosslinking agent based on a low-molecular-weight aliphatic polyhydric alcohol esterified with (meth)acrylic acid,
C) oligomers or polymers containing olefinically unsaturated groups, which can be copolymerized with acrylates and have a slight crosslinking action, for the purpose of flexibilization,
D) a photoinitiator system for UV light, and also
E) a thermally activable radical starter,
from which adhesive composition an adhesive bond can be produced which is resistant to a soldering process and which can also be dissolved with a solvent after the soldering process to leave no residue.

2. Adhesive composition according to Claim 1, characterized in that further standard additives such as coinitiators, stabilizers or pigments are present.

3. Adhesive composition according to Claim 1 or 2, characterized in that the component A is present in a proportion of 30 to 70 per cent by weight.

4. Adhesive composition according to one of Claims 1 to 3, characterized in that, as component C, a butadiene/acrylonitrile copolymer containing vinyl terminal groups is present in a proportion of 10 to 50 per cent by weight.

5. Adhesive composition according to at least one of Claims 1 to 4, characterized in that a peroxide is present as radical starter.

6. Adhesive composition according to at least one of Claims 1 to 5, characterized in that a suitable amine is present which eliminates the oxygen inhibition during the UV curing of the adhesive composition.

7. Adhesive composition according to at least one of Claims 1 to 6, characterized in that a photoinitiator system which is predominantly sensitive to light below 400 nm is present.

8. Process for mounting semiconductor chips (31, 32...36) on a device (5) with the aid of an adhesive composition according to Claim 1, characterized by the following process steps:
- application of a UV-curable adhesive layer according to Claim 1 to the regions of a temporary carrier provided as adhesion sites (21, 22...26),
- placing of the semiconductor chips (31..) to be mounted over the adhesion sites (21..) on the temporary carrier (1) with the active side opposite the later soldering site in a mirror-inverted arrangement (with respect to the later mounting on the device 5),
- determining the precise positions of the semiconductor chips on the temporary carrier (1) relative to a specified position and, if necessary, aligning the semiconductor chips in accordance with said specified positions,
- fixing the positions of the semiconductor chips by irradiating the adhesive layer with UV light,
- curing the adhesive layer at elevated temperature,
- soldering the rear side of the semiconductor chips glued to the temporary carrier (1) to the device (5) in a soldering process, and
- releasing the adhesive bond between the semiconductor chips and the temporary carrier and dissolving all the adhesive residues on the semiconductor chips by means of a solvent.

9. Process according to Claim 8, characterized in that the relative positions of the semiconductor chips (31) on the carrier are determined by means of optical measuring methods, in particular by means of a microscope, and in that the shorter-wave components are filtered out of the light used for this purpose by means of a colour filter.

10. Process according to either Claim 8 or 9, characterized in that the light used to fix the adhesive bond is presented by means of an optical waveguide.

11. Process according to one of Claims 8 to 10, characterized in that vapour-phase soldering (= vapour-phase process) is carried out as soldering process.

12. Process according to at least one of Claims 8 to 11, characterized in that a photoresist stripper is used as solvent.

13. Process according to at least one of Claims 8 to 12, characterized in that an adhesive composition described by one of Claims 1 to 7 is used.

## Revendications

1. Composition adhésive durcissable sous l'effet des ultraviolets, notamment pour le montage de puces à semiconducteurs, comportant
A) au moins un acrylate (méthacrylate) monofonctionnel d'un alcool aliphatique ou cycloaliphatique comportant de 6 à 20 atomes de C,
B) un agent de réticulation réactif polyfonctionnel à base d'un polyalcool aliphatique à bas poids moléculaire, estérifié par l'acide acrylique (méthacrylique),
C) des oligomères ou des polymères, qui peuvent être copolymérisés avec des acrylates, qui produisent une réticulation facile et qui comportent des groupes à insaturation oléfinique, pour fournir de la souplesse,
D) un système photoinitiateur pour le rayonnement ultraviolet, et
E) un initiateur de radicaux, pouvant être activé thermiquement,
et à partir de laquelle on peut réaliser une liaison adhésive résistante à une opération de brasage et qui peut être également dissoute sans résidu, après l'opération de brasage, à l'aide d'un solvant.

2. Composition adhésive suivant la revendication 1, caractérisée par le fait qu'elle renferme d'autres additifs usuels tels que des co-initiateurs, des stabilisateurs ou des pigments.

3. Composition adhésive suivant la revendication 1 ou 2, caractérisée par le fait que le constituant A est contenu en un pourcentage de 30 à 70 pour cent en poids.

4. Composition adhésive suivant l'une des revendications 1 à 3, caractérisée par le fait qu'elle renferme, comme constituant C, un copolymère butadiène/ acrylonitrile comportant des groupes d'extrémité vinyle, en une proportion comprise entre 10 et 50 pour cent en poids.

5. Composition adhésive suivant au moins l'une des revendications 1 à 4, caractérisée par le fait qu'elle renferme un peroxyde en tant qu'initiateur de radicaux.

6. Composition d'adhésif suivant au moins l'une des revendications 1 à 5, caractérisée par le fait qu'elle renferme une amine appropriée, qui exclut l'inhibition par l'oxygène lors du durcissement de la composition adhésive sous l'effet des ultraviolets.

7. Composition adhésive suivant au moins l'une des revendications 1 à 6, caractérisée par le fait qu'elle renferme un système photoinitiateur, qui est sensible d'une manière prépondérante à la lumière inférieure à 400 nm.

8. Procédé de montage de puces à semiconducteurs (31, 32... 36) sur un composant (5) à l'aide d'une composition adhésive selon la revendication 1, caractérisé par les étapes opératoires suivantes :
- dépôt d'une couche d'adhésif durcissable aux ultraviolets suivant la revendication 1, sur les zones d'un support auxiliaire, prévues en tant que zones de collage (21, 22 ...26),
- pose des puces à semiconducteurs (31...), devant être montées, par les points de collage (21...), sur le support auxiliaire (1), la face active, située à l'opposé de la zone du point de brasage formé ultérieurement, étant disposée symétriquement comme en un miroir (par rapport au montage ultérieur sur le composant 5),
- détermination des positions précises des puces à semiconducteurs sur le support auxiliaire (1) par rapport à une position donnée à l'avance et éventuellement alignement des puces à circuits imprimés conformément à ces positions données à l'avance,
- fixation des positions de la puce à circuits imprimés par exposition de la couche d'adhésif à de la lumière ultraviolette,
- durcissement de la couche d'adhésif à une température élevée,
- fixation par brasage des puces à circuits imprimés, fixées par adhérence sur le support auxiliaire (1), par leur face arrière, au composant (5), lors d'une procédure de brasage, et
- suppression de la liaison par adhérence entre les puces à semiconducteurs et le support auxiliaire et dissolution de tous les restes d'adhésif sur les puces à semiconducteurs, au moyen de solvant.

9. Procédé suivant la revendication 8, caractérisé par le fait que la détermination des positions relatives des puces à semiconducteurs (31) sur le support est réalisée au moyen de procédés optiques de mesure, notamment par l'intermédiaire d'un microscope, et que les composants de courte longueur d'onde sont séparés par filtrage de la lumière utilisée à cet effet, au moyen d'un filtre coloré.

10. Procédé suivant l'une des revendications 8 ou 9, caractérisé par le fait que la lumière utilisée pour la fixation de la liaison par adhérence, est amenée au moyen d'un guide de lumière.

11. Procédé suivant l'une des revendications 8 à 10, caractérisé par le fait qu'on exécute, comme procédure de brasage, un brasage en phase vapeur (= processus vapour phase).

12. Procédé suivant au moins l'une des revendications 8 à 11, caractérisé par le fait qu'on utilise comme solvant un agent d'élimination du vernis photosensible.

13. Procédé suivant au moins l'une des revendications 8 à 12, caractérisé par le fait qu'on utilise une composition adhésive décrite dans l'une des revendications 1 à 7.
